# EUROPEAN PATENT SPECIFICATION

(11) **EP 2 843 372 B1**
(45) Date of publication and mention of the grant of the patent: **01.06.2016**
(21) Application number: 14181633.0
(22) Date of filing: 20.08.2014
(51) Int. Cl.: G01D 5/16, G01R 33/09, G01B 7/30

(54) **Angle detection device**
Winkelerfassungsvorrichtung
Dispositif de détection d'angle

(30) Priority: 29.08.2013 JP 2013178567
(43) Date of publication of application: 04.03.2015
(73) Proprietor: Alps Electric Co., Ltd., Tokyo 145-8501 (JP)
(72) Inventor: Nakamura, Tokuo, Tokyo (JP)
(74) Representative: Klunker . Schmitt-Nilson . Hirsch

(56) References cited:
- EP-A1- 1 096 234
- EP-A1- 1 830 155
- EP-A1- 2 589 934
- WO-A2-2007/149200

## Description

The present invention relates to an angle detection device in which a plurality of magnetic detection units detect a rotation magnetic field to obtain an analog output approximating a linear function which is proportional to a rotation angle.

As an angle detection device that detects a rotation angle of a rotational body with a magnet, an angle detection device with a bridge circuit including a magnetoresistive effect element is used. Typically, two sets of bridge circuits are used to obtain a detection output approximating a sine wave from one bridge circuit, whereby a detection output approximating a cosine wave can be obtained from the other bridge circuit.

In order to detect the rotation angle of the rotational body, it is necessary to obtain a detection output of a linear function which is proportional to the rotation angle. In order to obtain the detection output of the linear function, an inverse tangent function (arctangent) is calculated from the detection output approximating the sine wave and the detection output approximating the cosine wave. In the related art, as a method of accurately calculating the inverse tangent function, a digital operation using an algorithm such as a codec is performed by A/D converting the detection output approximating the sine wave and the detection output approximating the cosine wave.

However, the digital operation using the algorithm has a disadvantage in that the operation is time-consuming. A highly accurate angle detection output can be obtained by the digital operation at a low rotation speed of the rotational body, but the operation cannot follow rotation of the rotational body when the rotational body rotates at a high rotation speed such as in a motor.

In JP 2010-54495 A and JP 2011-508891 A, an angle detection device for obtaining a detection output close to a linear function without using a digital operation is disclosed.

In the angle detection device described in JP 2010-54495 A, a magnetic sensor with a combination of a magnet and a magnetoresistive effect element is used. A rotational body is made of a ferromagnetic material, and a planar shape of the rotational body is a shape with a tangent function (tangent) added rather than a perfect circle. Using the rotational body, the detection output approximating the linear function can be obtained from the magnetic sensor.

However, it is very difficult to manufacture the rotational body with the tangent function added rather than the circle, and the manufacturing costs are increased.

In the angle detection device described in JP 2011-508891 A, a rotating magnet and four sensor elements facing the rotating magnet are provided. Outputs approximating a sine wave and a cosine wave can be obtained from the sensor element, so that indirect division is performed by an analog multiplier from the two outputs. However, in the analog multiplier, an analog division circuit is required for a signal processing unit, and therefore the circuit configuration becomes complex.

The present invention provides an angle detection device which can obtain an angle detection output approximating a linear function through a simple circuit configuration and follow a high-speed rotation.

According to an aspect of the present invention, there is provided an angle detection device including: a first magnetic detection unit configured to be provided in a detection area to which a rotational magnetic field is applied so as to obtain a detection output approximating a sine wave being a function of a rotation angle of the rotational magnetic field; a second magnetic detection unit configured to be provided in the detection area to which the rotational magnetic field is applied so as to obtain a detection output approximating a cosine wave being a function of the rotation angle of the rotational magnetic field; a switching circuit configured to cut out a plurality of partial detection outputs approximating a linear function from analog detection outputs obtained from the first and second magnetic detection units; and a bias adding circuit configured to enable the plurality of partial detection outputs to be consecutive by applying a bias power to any one of the partial detection outputs so that the consecutive partial detection outputs are used as angle detection outputs.

In the angle detection device according to the aspect of the invention, the analog detection outputs obtained from the magnetic detection units may be cut out to be consecutive by the switching circuit, and therefore the speed may be high and the circuit configuration may be simple in order to obtain the angle detection output. In addition, the analog outputs obtained from the magnetic detection units are used as is, or used by only passing through gain adjustment or the like, and therefore the angle detection output directly connected to the rotation angle of the rotational body can be obtained.

The angle detection device according to the aspect of the invention may further include: an output circuit configured to obtain a first detection output from the first magnetic detection unit and a second detection output obtained by reversing positive/negative polarity with the first detection output, and a third detection output from the second magnetic detection unit and a fourth detection output obtained by reversing positive/negative polarity with the third detection output; and a comparator configured to compare the first or second detection output and any one of the third and fourth detection outputs. Here, switching timing of the switching circuit may be determined based on a comparison output from the comparator.

In the angle detection device according to the aspect of the invention, each of the first, second, third, and fourth detection outputs may be cut out at intervals of 90 degrees by the switching circuit so that the partial detection outputs may be obtained.

In the angle detection device according to the aspect of the invention, the first, second, third, and fourth detection outputs may be cut out in a range of ±45 degrees with a midpoint of the amplitude as a starting point. Accordingly, by obtaining the partial detection output in this range, the partial detection output approximating the linear function can be obtained.

In the angle detection device according to the aspect of the invention, each of the first and second magnetic detection units may be constituted of a bridge circuit including a magnetoresistive effect element, and in a first magnetoresistive effect element included in the first magnetic detection unit and a second magnetoresistive effect element included in the second magnetic detection unit, directions of sensitivity axes may be orthogonal to each other.

In the angle detection device according to the aspect of the invention, an analog output can be cut out from each of the first magnetic detection unit and the second magnetic detection unit in the switching circuit, and consecutive angle detection output obtained by applying bias can be obtained. Therefore, a circuit configuration is simple, and even when a rotation speed of the rotational body is high, the angle detection output which rapidly follows rotation can be obtained.

### BRIEF DESCRIPTION OF THE DRAWINGS

Fig. 1 is a plan diagram showing a rotational body and a magnetic detection unit in an angle detection device according to an embodiment of the present invention;
Fig. 2 is a circuit block diagram showing a circuit configuration of an angle detection device according to an embodiment of the present invention;
Fig. 3 is a line diagram showing four types of detection outputs from first and second magnetic detection units;
Fig. 4 is a line diagram showing a partial detection output obtained by cutting a detection output from first and second magnetic detection units;
Fig. 5 is a line diagram showing an angle detection output in which partial detection outputs are consecutive; and
Fig. 6 is a line diagram showing distribution of errors between the angle detection output shown in Fig. 5 and a linear function.

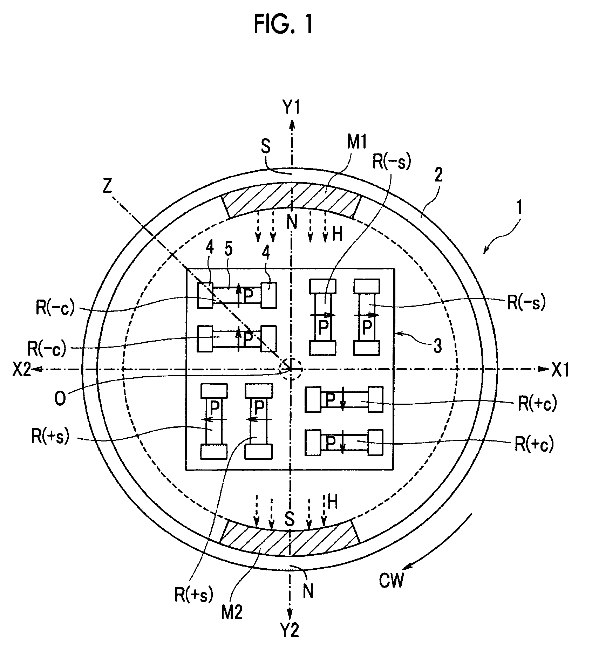

As shown in Fig. 1, an angle detection device 1 according to an embodiment of the present invention has a rotational body 2, and a detection substrate 3 is disposed on an inner side of the rotational body 2.

In the rotational body 2, two magnets M1 and M2 are mounted at intervals of 180 degrees. An N pole of the magnet M1 is directed to the magnet M2, an S pole of the magnet M2 is directed to the magnet M1, and a magnetic field H is formed from the magnet M1 toward the magnet M2.

The rotational body 2 has a rotational center O and rotates clockwise (CW). As a result, on an inner side of the rotational body 2, a rotational magnetic field in which the magnetic field H rotates clockwise is formed.

On the detection substrate 3, first magnetoresistive effect elements R(+s) and R(-s) and second magnetoresistive effect elements R(+c) and R(-c) are mounted as magnetic detection elements. In Fig. 1, the detection substrate 3 and the magnetoresistive effect elements are shown to be large, but the detection substrate 3 and the magnetoresistive effect elements are actually much smaller in dimension than a diameter of a rotating locus of the magnets M1 and M2. When the rotational body 2 rotates, the rotational magnetic field in the same direction is applied to each of the magnetoresistive effect elements on the detection substrate 3.

In addition, despite a configuration in which the magnets M1 and M2 are fixed in a fixing unit and the detection substrate 3 is rotated counterclockwise about the rotational center O, it is possible to provide the rotational magnetic field which rotates clockwise (CW) relative to the detection substrate 3.

In the first magnetoresistive effect elements R(+s) and R(-s) and the second magnetoresistive effect elements R(+c) and R(-c), directions of sensitivity axes P are orthogonal to each other. Two kinds of the first magnetoresistive effect elements are provided. Here, the direction of the sensitivity axis P of R(+s) is an X2 direction, and the direction of the sensitivity axis P of R(-s) is an X1 direction. Two kinds of the second magnetoresistive effect elements are provided. Here, the direction of the sensitivity axis P of R(+c) is a Y2 direction, and the direction of the sensitivity axis P of R(-c) is a Y1 direction.

The magnetoresistive effect element is a GMR element using a giant magnetoresistive effect, a TMR element using a tunnel effect, or an AMR element.

As shown in Fig. 1, the magnetoresistive effect element includes electrode portions 4 and 4 and an element portion 5 positioned between the electrode portions 4. The element portion 5 is formed in a meander pattern within the plane of an X-Y plane, and is configured by laminating a fixed magnetic layer/a non-magnetic layer/a free magnetic layer. The fixed magnetization direction of the fixed magnetic layer coincides with the direction of the sensitivity axis P. In the free magnetic layer, a magnetization direction can be changed in accordance with a direction of an external magnetic field H.

When the external magnetic field H is applied in the direction of the sensitivity axis P, an electric resistance value of the magnetoresistive effect element is a minimum value, and when the external magnetic field H is applied in a reverse direction with respect to the sensitivity axis P, the electric resistance value thereof is a maximum value. When the external magnetic field H is applied in a direction orthogonal to the sensitivity axis P, the electric resistance value of the magnetoresistive effect element is a value of the midpoint of the minimum value and the maximum value.

The fixed magnetic layer may be superimposed on an antiferromagnetic layer to be subjected to heat treatment in the magnetic field, so that the magnetization direction is fixed. Alternatively, the fixed magnetic layer may have a lamination ferry structure of the magnetic layer/the non-magnetic intermediate layer/the magnetic layer, and the respective magnetic layers may have a self pinning type which is magnetized and fixed in anti-parallel. In this case, the magnetization is fixed by forming one magnetic layer in the magnetic field.

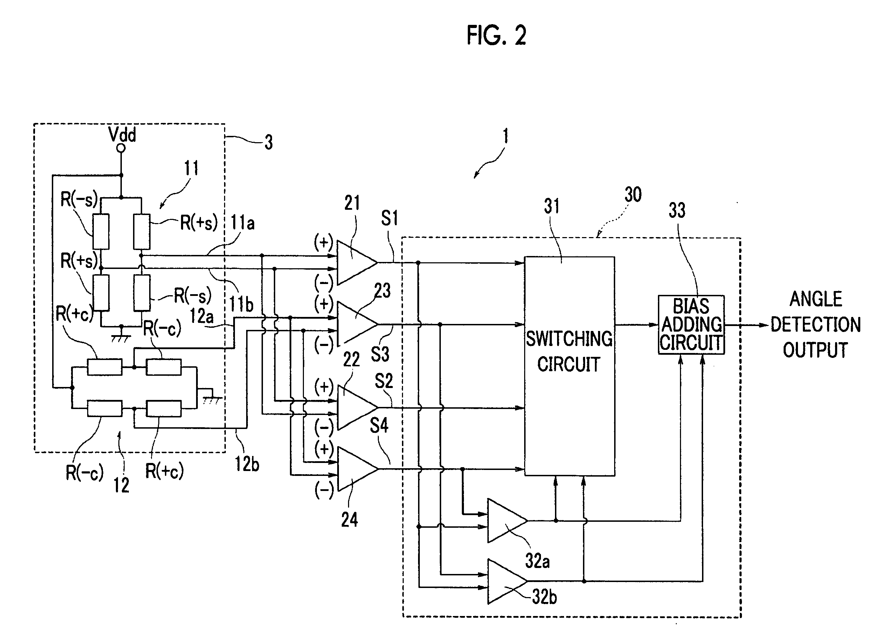

As shown in Fig. 2, in the angle detection device 1, a first magnetic detection unit 11 and a second magnetic detection unit 12 are configured on the detection substrate 3.

The first magnetic detection unit 11 is a full bridge circuit constituted of the first magnetoresistive effect elements R(+s) and R(-s) with the directions of the sensitivity axes P different from each other by 180 degrees. The second magnetic detection unit 12 is a full bridge circuit constituted of the second magnetoresistive effect elements R(+c) and R(-c) with the directions of the sensitivity axes P different from each other by 180 degrees.

As shown in Fig. 2, midpoint outputs (midpoint output voltages) 11a and 11b of the full bridge circuit of the first magnetic detection unit 11 may be applied to a first output circuit 21 and a second output circuit 22. The first output circuit 21 is a differential amplifier, and the midpoint output 11a is connected to a (+) input unit and the midpoint output 11b is connected to a (-) input unit. The second output circuit 22 is also a differential amplifier, and the midpoint output 11b is connected to the (+) input unit and the midpoint output 11a is connected to the (-) input unit.

Midpoint outputs (midpoint output voltages) 12a and 12b of the full bridge circuit of the second magnetic detection unit 12 may be applied to a third output circuit 23 and a fourth output circuit 24. The third output circuit 23 is a differential amplifier, and the midpoint output 12a is connected to the (+) input unit and the midpoint output 12b is connected to the (-) input unit. The fourth output circuit 24 is also a differential amplifier, and the midpoint output 12b is connected to the (+) input unit and the midpoint output 12a is connected to the (-) input unit.

When the rotational body 2 shown in Fig. 1 rotates clockwise (CW), a first detection output S1 may be obtained from the first output circuit 21, and a second detection output S2 may be obtained from the second output circuit 22. A third detection output S3 may be obtained from the third output circuit 23, and a fourth detection output S4 may be obtained from the fourth output circuit 24.

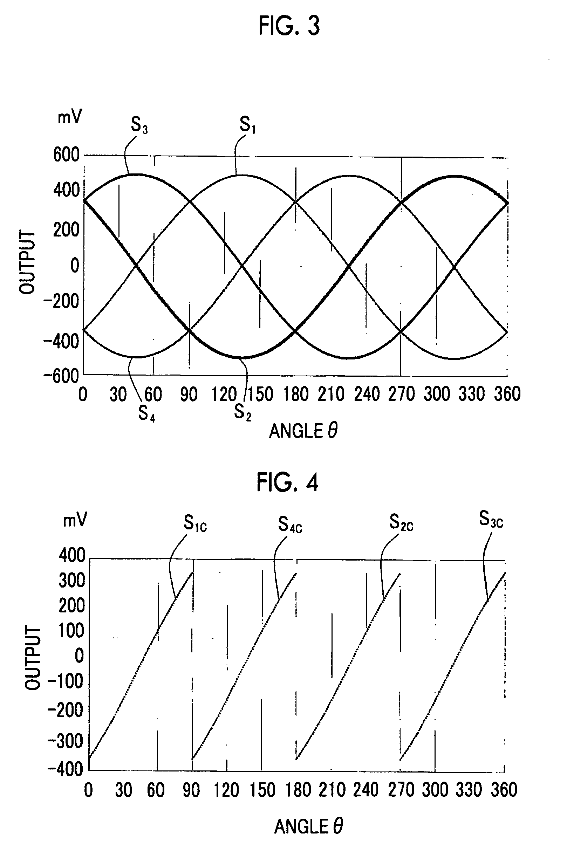

In Fig. 3, output waveforms of the first to fourth detection outputs S1 to S4 are shown. The horizontal axis indicates rotation angle (θ), and the vertical axis indicates output intensity (voltage).

In the first detection output S1 and the second detection output S2, the polarities (positive and negative voltage) are reversed, and also in the third detection output S3 and the fourth detection output S4, the polarities are reversed. In the first detection output S1 and the third detection output S3, the phases are different from each other by 90 degrees, and in the second detection output S2 and the fourth detection output S4, the phases are also different from each other by 90 degrees. One of the first detection output S1 and the third detection output S3 is an output having a change approximating a trigonometric function wave of a sine wave, and the other thereof is an output having a change approximating a trigonometric wave of a cosine wave.

The rotation angle θ of the rotational body 2 is shown in the horizontal axis of Fig. 3, but the representation of the rotation angle θ uses a case in which a width center of the magnet M1 shown in Fig. 1 coincides with each other on a reference line Z, as the origin (0 degrees). Fig. 1 shows a state in which the magnet M1 of the rotational body 2 in rotation advances by 45 degrees clockwise (CW) with the origin (reference axis Z) as a starting point. In this instance, output intensities of the first to fourth detection outputs S1 to S4 become an output intensity when the horizontal axis in Fig. 3 is 45 degrees. When the horizontal axis is 45 degrees, the output intensity of the first detection output S1 and the output intensity of the second detection output S2 are values of midpoints, the output intensity of the third detection output S3 is a maximum value, and the output intensity of the fourth detection output S4 is a minimum value.

Absolute values and amplitudes of intensities of output waveforms of the first to fourth detection outputs S1 to S4 shown in Fig. 3 depend on a gain or the like which is set to a power supply voltage Vdd and depend on the output circuits 21, 22, 23, and 24 each being a differential amplifier. The first to fourth detection outputs S1 to S4 are analog outputs in which changes in the detection outputs from the first and second magnetic detection units 11 and 12 which detect a rotational magnetic field are reflected as is.

As shown in Fig. 2, the first to fourth detection outputs S1 to S4 are applied to an analog mixer 30. The analog mixer 30 has a switching circuit 31, comparators 32a and 32b, and a bias adding circuit 33.

The first comparator 32a may compare the level of the intensities of the first detection output S1 and the fourth detection output S4, and the comparison result may be applied to the switching circuit 31. The second comparator 32b may compare the level of the intensities of the first detection output S1 and the third detection output S3, and the comparison result may be applied to the switching circuit 31.

The switching circuit 31 performs a switching operation based on the comparison results of the comparators 32a and 32b so that the detection output is cut out as a partial detection output in which any one of the first to fourth detection outputs S1 to S4 is selected.

Based on the comparison result of the first comparator 32a, the comparison result of the second comparator 32b, and the comparison result therebetween, the detection output which is cut out in the switching circuit 31 is as described in Table 1 below.

**[Table 1]**

| First comparator 32a | Second comparator 32b | Switching output (partial detection output) | Bias voltage |
|---|---|---|---|
| S1>S4 | S1<S3 | S1(S1c) | +350 mV |
| S1>S4 | S1>S3 | S9 (S4c) | +1050 mV |
| S1<S4 | S1>S3 | S2 (S2c) | +1750 mV |
| S1<S4 | S1<S3 | S3(S3c) | +2450 mV |

In Fig. 4, partial detection outputs S1c, S4c, S2c, and S3c which are cut out by the switching operation of the switching circuit 31 are shown.

As shown in Table 1, switching is performed in the switching circuit 31 by comparing two detection outputs in each of the first comparator 32a and the second comparator 32b, and therefore four detection outputs are cut out at intervals of 90 degrees while the rotational body 2 rotates 360 degrees clockwise as shown in Fig. 4.

When the angle θ is between 0 and 90 degrees, as shown in the first column of Table 1, the first detection output S1 is cut out back and forth relative to a midpoint of its amplitude (voltage width) in a range of 45 degrees, thereby obtaining a partial detection output S1c shown in Fig. 4. When the angle θ is between 90 and 180 degrees, as shown in the second column of Table 1, the fourth detection output S4 is cut out back and forth relative to a midpoint of its amplitude (voltage width) in a range of 45 degrees, thereby obtaining a partial detection output S4c shown in Fig. 4. In the same manner, a partial detection output S2c may be obtained when the angle of θ is between 180 and 270 degrees, and a partial detection output S3c may be obtained when the angle of θ is between 270 and 360 degrees.

Since the partial detection outputs S1c, S4c, S2c, and S3c are cut out back and forth relative to the midpoint of the amplitude in the range of ±45 degrees among the detection outputs approximating the sine wave and the cosine wave, a change in output intensity becomes nearly a linear function.

The first comparator 32a and the second comparator 32b generate a signal for dividing the detection output for each interval of 90 degrees in which the partial detection output shown in Fig. 4 can be obtained. To the extent that this is possible, compared detection outputs are not limited to the example shown in Table 1.

For example, even in a comparison condition of S3>S1 and S3>S2, the first detection output S1 can be cut out when the angle of θ is in a range of 0 to 90 degrees, thereby obtaining the partial detection output S1c.

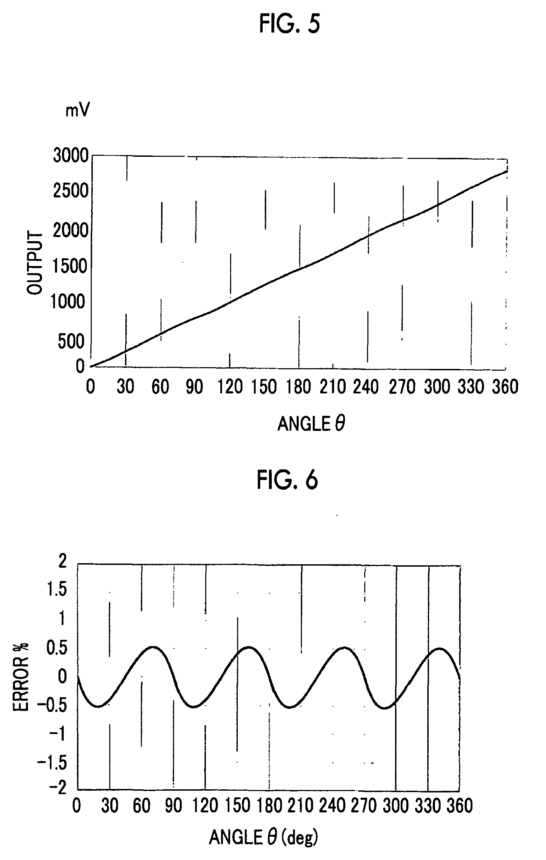

The partial detection outputs S1c, S4c, S2c, and S3c which are cut out in the switching circuit 31 are applied to the bias adding circuit 33. In the bias adding circuit 33, a positive or negative bias voltage is applied to the partial detection outputs S1c, S4c, S2c, and S3c, whereby an angle detection output approximating the linear function in which the partial detection outputs S1c, S4c, S2c, and S3c are consecutive can be obtained as shown in Fig. 5. In the rightmost column of Table 1, in order to obtain the angle detection output shown in Fig. 5, the bias voltages applied to the partial detection outputs S1c, S4c, S2c, and S3c are shown numerically.

The bias adding circuit is constituted of a resistor, a variable resistor, and the like, and the bias voltage is applied to the partial detection output S4c so that a starting end of the partial detection output S4c shown in Fig. 4 is connected to a terminating end of the partial detection output S1c. Similarly, the bias voltage is applied to the partial detection outputs S2c and S3c. In addition, by applying the positive or negative bias voltage to the partial detection output S1c which can be first obtained, a starting point of the output when the angle θ is 0 degrees can be aligned with the origin of the output voltage as shown in Fig. 5.

The change in the angle detection output shown in Fig. 5 is approximating a linear function. Fig. 6 shows an intensity error between the angle detection output shown in Fig. 5 and the linear function. An error for the linear function of the angle detection output is approximately ±0.5%.

In the angle detection device 1 according to an embodiment of the present invention, an analog output which can be obtained from the first magnetic detection unit 11 and the second magnetic detection unit 12 is used as is or used by performing gain adjustment, whereby the angle detection output approximating the linear function can be instantaneously obtained. Thus, even when the rotational body 2 rotates to be directly connected to a motor, it is possible to accurately detect a rotation angle.

In addition, in the angle detection device 1 shown in Figs. 1 and 2, the first magnetic detection unit 11 is a full bridge circuit constituted of the first magnetoresistive effect elements R(+s) and R(-s), and the second magnetic detection unit 12 is a full bridge circuit constituted of the second magnetoresistive effect elements R(+c) and R(-c).

However, in the present invention, the first magnetic detection unit 11 may be a half-bridge circuit using any one of R(+s) and R(-s) as the first magnetoresistive effect element, and the second magnetic detection unit 12 may be a half-bridge circuit using any one of R(+c) and R(-c) as the second magnetoresistive effect element.

In addition, in the analog mixer 30 shown in Fig. 2, the bias power is applied to each of the partial detection outputs cut out in the switching circuit 31, but the bias power is applied in advance to the first to fourth detection outputs S1 to S4 having passed through the first to fourth output circuits 21, 22, 23, and 24, and therefore consecutive angle detection outputs may be obtained from the switching circuit 31 by cutting out the partial detection output in the switching circuit 31.

It should be understood by those skilled in the art that various modifications, combinations, sub-combinations and alterations may occur depending on design requirements and other factors insofar as they are within the scope of the appended claims or the equivalents thereof.

## Claims

1. An angle detection device (1) comprising:
a first magnetic detection unit (11) configured to be provided in a detection area to which a rotational magnetic field (H) is applied so as to obtain a detection output approximating a sine wave being a function of a rotation angle of the rotational magnetic field;
a second magnetic detection unit (12) configured to be provided in the detection area to which the rotational magnetic field is applied so as to obtain a detection output approximating a cosine wave being a function of the rotation angle of the rotational magnetic field;
a switching circuit (31) configured to cut out a plurality of partial detection outputs (S1c-S4c) approximating a linear function from analog detection outputs (S1-S4) obtained from the first and second magnetic detection units as is or by performing gain adjustment; and
a bias adding circuit (33) configured to enable the plurality of partial detection outputs (S1c-S4c) to be consecutive by applying a bias power to each of the partial detection outputs (S1c-S4c) so that the consecutive partial detection outputs approximate a linear function and are used as angle detection outputs.

2. The angle detection device according to Claim 1, further comprising:
an output circuit (21-24) configured to obtain a first detection output (S1) from the first magnetic detection unit (11) and a second detection output (S2) obtained by reversing positive/negative polarity with the first detection output (S1), and a third detection output (S3) from the second magnetic detection unit (12) and a fourth detection output (S4) obtained by reversing positive/negative polarity with the third detection output (S3); and
a comparator (32a, 32b) configured to compare the first or second detection output and any one of the third and fourth detection outputs,
wherein switching timing of the switching circuit (31) is determined based on a comparison output from the comparator.

3. The angle detection device according to Claim 2, wherein each of the first, second, third, and fourth detection outputs (S1-S4) is cut out at intervals of 90 degrees by the switching circuit (31) so that the partial detection outputs are obtained.

4. The angle detection device according to Claim 2 or 3, wherein the first, second, third, and fourth detection outputs (S1-S4) are cut out in a range of ±45 degrees with a midpoint of the amplitude as a starting point.

5. The angle detection device according to one of Claims 1-4, wherein each of the first and second magnetic detection units (11, 12) is constituted of a bridge circuit including a magnetoresistive effect element, and in a first magnetoresistive effect element included in the first magnetic detection unit and a second magnetoresistive effect element included in the second magnetic detection unit, directions of sensitivity axes are orthogonal to each other.

## Patentansprüche

1. Winkelerfassungsvorrichtung (1), aufweisend:
eine erste Magnetismus-Detektionseinheit (11), die dazu ausgebildet ist, in einem Detektionsbereich vorgesehen zu werden, an den ein Rotationsmagnetfeld (H) angelegt wird, um ein an eine Sinuswelle angenähertes Detektionsausgangssignal als Funktion eines Rotationswinkels des Rotationsmagnetfelds zu erhalten;
eine zweite Magnetismus-Detektionseinheit (12), die dazu ausgebildet ist, in dem Detektionsbereich vorgesehen zu werden, an den das Rotationsmagnetfeld angelegt wird, um ein an eine Kosinuswelle angenähertes Detektionsausgangssignal als Funktion des Rotationswinkels des Rotationsmagnetfelds zu erhalten;
eine Schaltung (31), die dazu ausgebildet ist, eine Mehrzahl von einer linearen Funktion angenäherten partiellen Detektionsausgangssignalen (S1c-S4c) aus von der ersten und der zweiten Magnetismus-Detektionseinheit erhaltenen analogen Detektionsausgangssignalen (S1-S4) auszuschneiden,
und zwar so wie sie sind oder unter Ausführung einer Verstärkungseinstellung; und
eine Vorspannungsadditionsschaltung (23), die dazu ausgebildet ist, eine aufeinander folgende Anordnung der Mehrzahl von partiellen Detektionsausgarigssignalen (S1c-S4c) zu ermöglichen durch Anlegen einer Vorspannungsleistung an jedes der partiellen Detektionsausgangssignale (S1c-S4c),
so dass die aufeinander folgenden partiellen Detektionsausgangssignale einer linearen Funktion angenähert sind und als Winkelerfassungsausgangssignale verwendet werden.

2. Winkelerfassungsvorrichtung nach Anspruch 1,
weiterhin aufweisend:
eine Ausgangsschaltung (21-24), die dazu ausgebildet ist, ein erstes Detektionsausgangssignal (S1) von der ersten Magnetismus-Detektionseinheit (11) und ein zweites Detektionsausgangssignal (S2), das durch Umkehren der positiven/negativen Polarität gegenüber dem ersten Detektionsausgangssignal gebildet ist, sowie ein drittes Detektionsausgangssignal (S3) von der zweiten Magnetismus-Detektionseinheit (12) und ein viertes Detektionsausgangssignal (S4), das durch Umkehren der positiven/negativen Polarität gegenüber dem dritten Detektionsausgangssignal (S3) gebildet ist, zu erhalten; und
einen Komparator (32a, 32b), der dazu ausgebildet ist, das erste oder das zweite Detektionsausgangssignal und ein beliebiges von dem dritten und dem vierten Detektionsausgangssignal miteinander zu vergleichen,
wobei der Schaltzeitpunkt der Schaltung (31) auf der Basis eines von dem Komparator abgegebenen Vergleichsausgangssignals bestimmt wird.

3. Winkelerfassungsvorrichtung nach Anspruch 2,
wobei jedes von dem ersten, zweiten, dritten und vierten Detektionsausgangssignal (S1-S4) durch die Schaltung (31) in Abständen von 90 Grad ausgeschnitten wird, so dass die partiellen Detektionsausgangssignale erhalten werden.

4. Winkelerfassungsvorrichtung nach Anspruch 2 oder 3,
wobei das erste, zweite, dritte und vierte Detektionsausgangssignal (S1-S4) in einem Bereich von ± 45 Grad mit einem Mittelpunkt der Amplitude als Ausgangspunkt ausgeschnitten werden.

5. Winkelerfassungsvorrichtung nach einem der Ansprüche 1 bis 4,
wobei jede von der ersten und der zweiten Magnetismus-Detektionseinheit (11, 12) aus einer Brückenschaltung mit einem Magnetowiderstandseffekt-Element gebildet ist, und wobei in einem ersten Magnetowiderstandseffekt-Element, das in der ersten Magnetismus-Detektionseinheit enthalten ist, und in einem zweiten Magnetowiderstandseffekt-Element, das in der zweiten Magnetismus-Detektionseinheit enthalten ist, Richtungen von Empfindlichkeitsachsen zueinander orthogonal sind.

## Revendications

1. Dispositif de détection d'angle (1) comprenant :
une première unité de détection magnétique (11) configurée pour être placée dans une zone de détection à laquelle un champ magnétique tournant (H) est appliqué de façon à obtenir une sortie de détection approximant une onde sinusoïdale étant une fonction d'un angle de rotation du champ magnétique tournant ;
une seconde unité de détection magnétique (12) configurée pour être placée dans la zone de détection à laquelle le champ magnétique tournant est appliqué de façon à obtenir une sortie de détection approximant une onde cosinus étant une fonction de l'angle de rotation du champ magnétique tournant ;
un circuit de communication (31) configuré pour couper une pluralité de sorties de détection partielles (S1c-S4c) approximant une fonction linéaire à partir de sorties de détection analogiques (S1-S4) obtenues depuis les première et seconde unités de détection magnétique telles quelles ou en réalisant un ajustement de gain ; et
un circuit d'ajout de polarisation (33) configuré pour permettre à la pluralité de sorties de détection partielles (S1c-S4c) d'être consécutives en appliquant un courant de polarisation à chacune des sorties de détection partielles (S1c-S4c) de telle manière que les sorties de détection partielle consécutives approximent une fonction linéaire et sont utilisées comme sorties de détection d'angle.

2. Dispositif de détection d'angle selon la revendication 1, comprenant en outre :
un circuit de sortie (21-24) configuré pour obtenir une première sortie de détection (S1) depuis la première unité de détection magnétique (11) et une seconde sortie de détection (S2) obtenue en inversant la polarité positive/négative avec la première sortie de détection (S1), et une troisième sortie de détection (S3) depuis la seconde unité de détection magnétique (12) et une quatrième sortie de détection (S4) obtenue en inversant la polarité positive/négative avec la troisième sortie de détection (S3) ; et
un comparateur (32a, 32b) configuré pour comparer la première ou seconde sortie de détection et l'une quelconque des troisième et quatrième sorties de détection,
dans lequel le moment de commutation du circuit de commutation (31) est déterminé en fonction d'une sortie de comparaison venant du comparateur.

3. Dispositif de détection d'angle selon la revendication 2, dans lequel chacune des première, seconde, troisième, et quatrième sorties de détection (S1-S4) est coupée à intervalles de 90 degrés par le circuit de commutation (31) de telle manière que les sorties de détection partielles sont obtenues.

4. Dispositif de détection d'angle selon la revendication 2 ou la revendication 3, dans lequel les première, seconde, troisième, et quatrième sorties de détection (S1-S4) sont coupées dans une plage de ±45 degrés avec un point milieu de l'amplitude comme point de départ.

5. Dispositif de détection d'angle selon l'une quelconque des revendications 1-4, dans lequel chacune des première et seconde unités de détection magnétiques (11, 12) est constituée d'un circuit de pont incluant un élément à effet magnétorésistif, et dans un premier élément à effet magnétorésistif inclus dans la première unité de détection magnétique et un second élément à effet magnétorésistif inclus dans la seconde unité de détection magnétique, les directions des axes de sensibilité sont orthogonales l'une à l'autre.
